# EUROPEAN PATENT APPLICATION

(11) **EP 1 638 135 A2**
(43) Date of publication of application: **22.03.2006**
(21) Application number: 05019177.4
(22) Date of filing: 03.09.2005
(51) Int. Cl.: H01L 21/00

(54) **Susceptor with surface roughness for high temperature substrate processing**

(30) Priority: 17.09.2004 US 610993 P
(71) Applicant: ASM INTERNATIONAL N.V., 3723 BC Bilthoven (NL)
(72) Inventor: Van Den Berg, Jannes Remco, Emmeloord, 8302 XD (NL); Grannemann, Ernst H.A., Hilversum, 1217 AD (NL)
(74) Representative: Sternagel, Fleischer, Godemeyer & Partner

(57) **Abstract**

Susceptors plates are formed having a minimum surface roughness. The wafer contact surfaces of the susceptor plates have a surface roughness Ra value of about 0.6 µm or more. The contact surface is otherwise flat and lacking in large protrusions. In addition, the susceptors have a low transparency to more closely match the heat absorption properties of the supported wafer. Advantageously, heat transfer from the susceptors to the wafers is highly uniform. Thus, using these susceptors to support the wafers during high temperature semiconductor processing (*e.g.*, at > 1000°C) results in no or few crystallographic slip lines being formed on the wafers.

## Description

### Background of the Invention

### Field of the Invention

This invention relates generally to semiconductor processing and, more particularly, to the susceptors used to support substrates during processing.

### Description of the Related Art

Semiconductor substrates, such as semiconductor wafers, can be processed in batches in vertical furnaces. In some arrangements, the substrates are accommodated in the furnace in a substrate support holder, such as a wafer boat, in which the wafers are supported, or susceptors, on substrate supports vertically spaced from one another and with their major surfaces oriented horizontally. During processing at high temperatures (*e.g*., at > about 1000°C) the yield strength of the wafers decreases and the wafers can sag under their own weight, can deform as a result of thermally induced stresses, or can deform as a result of a combination of these effects. The deformations can cause crystallographic slip in the wafers. Wafers with large diameters are more susceptible deformation than wafers with small diameters, since the thicknesses of the wafers do not increase proportionally with their diameter.

To minimize these deformations, the susceptors can take the form of plates which have a support surface that spans substantially across the entire bottom surface of a wafer. U.S. Patent Application Publication No. 20040040632 A1, the entire disclosure of which is incorporated by reference herein, provides examples of such susceptors.

Crystallographic slip, however, can still occur even when wafers are processed while supported on these susceptors and even when the susceptors are made highly flat and smooth. Moreover, the amount of slip and the quality of the process results on different wafers have been found to vary from wafer to wafer within the batch of wafers in a wafer boat.

Accordingly, there is a need for processing methods and apparatuses that cause minimal crystallographic slip in processed substrates and that allow consistent processing results among the different substrates in a batch of substrates.

### Summary of the Invention

According to one aspect of the invention, a semiconductor substrate support is provided. The support comprises an upper surface configured to directly contact and support a semiconductor substrate. The upper surface has a surface roughness Ra value of about 0.6 µm or more.

According to another aspect of the invention, a susceptor for supporting a semiconductor substrate is provided. The susceptor comprises a substrate contact surface for directly contacting the substrate. The susceptor is formed of silicon carbide and a transparency-reducing material. The transparency of the susceptor is less than about 50%. The susceptor is configured to be accommodated in a wafer boat.

According to yet another aspect of the invention, a batch reactor is provided. The batch reactor comprises a vertical furnace having a reaction chamber. A substrate support holder is configured to be accommodated in the reaction chamber. The substrate support holder comprises a plurality of slots for substrate supports. The reactor also comprises a plurality of substrate supports for supporting semiconductor substrates. Each substrate support has a substrate contact surface with a surface roughness Ra value of about 0.6 µm or more. The substrate supports are each configured to be accommodated in one of the plurality of slots.

According to another aspect of the invention, a method of semiconductor processing is provided. The method comprises providing a semiconductor substrate supported on a substrate support in a reaction chamber. The substrate support directly contacts the substrate at a substrate support surface of the substrate support. The method also comprises subjecting the substrate to thermal processing. The substrate support surface has a surface roughness Ra value of about 0.6 µm or more.

According to yet another aspect of the invention, a method is provided for forming a substrate support for semiconductor processing. The method comprises providing a substrate support having a surface configured to contact a wafer. The surface is roughened until it has an Ra value of about 0.6 µm or more.

### Brief Description of the Drawings

The invention will be better understood from the Detailed Description of the Preferred Embodiments and from the appended drawings, which are meant to illustrate and not to limit the invention, and wherein:

Figure 1 is a schematic, top view of a susceptor, in accordance with preferred embodiments of the invention;

Figure 2 is a schematic, cross-sectional side view of a furnace provided with a wafer boat and susceptors, in accordance with preferred embodiments of the invention; and

Figure 3 is a graph showing radiative and conductive heat transfer coefficients (alpha, α) as a function of distance between a wafer and a susceptor.

### Detailed Description of the Preferred Embodiments

Even when a batch of wafers is processed using susceptor plates, which substantially support the entire bottom surface of the wafers, some wafers in the batch can be essentially slip-free, while others may show thousands of crystallographic slip lines. These results occur even when the plates are very smooth and flat.

It has been found that these non-uniformities in processing results are due to variations between individual susceptor plates. The crystallographic slip caused by particular susceptors was found to be repeatable and consistent for individual susceptors, even where the susceptors were very smooth and flat, e.g., even where the susceptors fulfilled the criteria regarding flatness and protrusion height disclosed in U.S. Patent Application Publication No. 20040040632 A1. For example, silicon wafers supported on certain susceptor plates during high temperature processing could be essentially slip-free after processing, while thousands of slip lines could be detected in simultaneously processed wafers supported on other susceptors.

It has been discovered that, in addition to flatness and the absence of large protrusions, surface roughness is an important factor for determining the occurrence of slip in silicon wafers subjected to high temperature processing. Contrary to expectations that slip decreases with increasing susceptor smoothness, it has been found that the slip can increase with smoothness; the smoothest susceptor plates resulted in the highest amount of crystallographic slip.

While this invention is not limited by theory, it is believed that uneven heat transfer between a susceptor and a substrate can contribute to the occurrence of crystallographic slip. Because susceptors typically have different thermal properties from substrates, a thermal gradient typically exists between the susceptor and the substrate at some point during processing, in particular during heat-up and cool-down. In addition, it is difficult to form perfectly flat substrates and susceptor plates. As a result, some parts of the substrate will directly contact the susceptor plate while other parts will be separated from the susceptor by small gaps. Heat transfer between the substrate and the susceptor plate will be better in the parts in direct contact with the susceptor plate than in the parts separated from the susceptor by gaps. As a consequence of this non-uniform heat transfer, the temperature across a substrate can vary from location to location, thereby causing slip.

It has been found that heat transfer from a substrate to a susceptor plate can be made more uniform by using a susceptor plate with a surface roughness that is equal to or larger than a certain minimal value. A rough surface reduces the amount of contact at the points where direct susceptor to substrate contact would occur, thereby minimizing heat transfer at those points and bringing the heat transfer at those points closer to the level of heat transfer at other points across the substrate. Thus, temperature non-uniformities are reduced and the occurrence of crystallographic slip is minimized.

In preferred embodiments, the surface roughness of the substrate contact surface of the susceptor has an Ra value about 0.6 µm or more, more preferably, about 1.0 µm or more and, most preferably, about 2.0 µm or more, as measured with a surface profilometer commercially available from Mitutoyo Corporation of Japan.

In addition, the effects of uneven heat transfer can be mitigated by better matching the temperatures of susceptors with the substrates that they support. For example, where the susceptor is cooler than the substrate, it will be appreciated that more heat is lost to the susceptor at the points of close contact with the susceptor than at the points where the substrate and the susceptor are separated by a relatively large gap. Advantageously, if the temperatures of the substrates and the suceptors are close together, the quantity of heat loss is less and any unevenness in heat transfer will affect the temperature of the substrate less than if the temperatures of the substrates and the susceptor varied by a larger degree.

Differences in substrate and susceptor temperature can arise where each has different heat absorption characteristics. For example, a silicon wafer can absorb over 90% of the heat impinging on its surface, while a transparent susceptor, such as those formed with silicon carbide, will only absorb about 30% of the heat contacting it. Thus, to increase the energy absorption of the susceptor plates, the transparency of the susceptors are preferably relatively low. In some preferred embodiments, the transparency of the susceptors is preferably less than about 50%, more preferably, less than about 30% and, most preferably, less than about 10%.

Reference will now be made to the Figures, in which like numerals refer to like parts throughout.

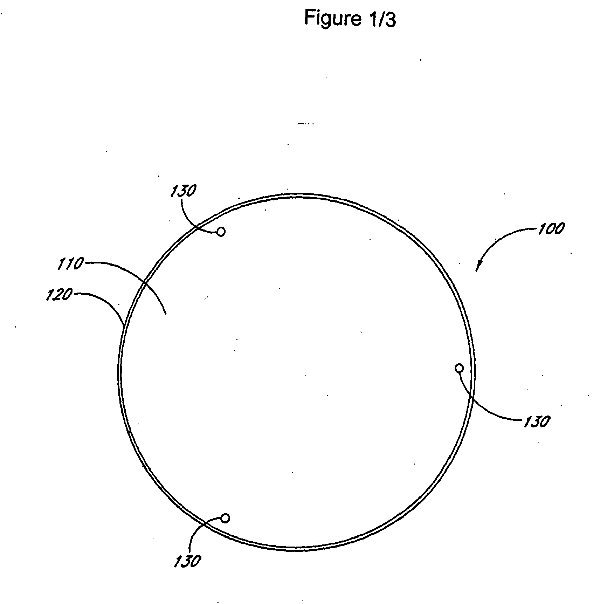

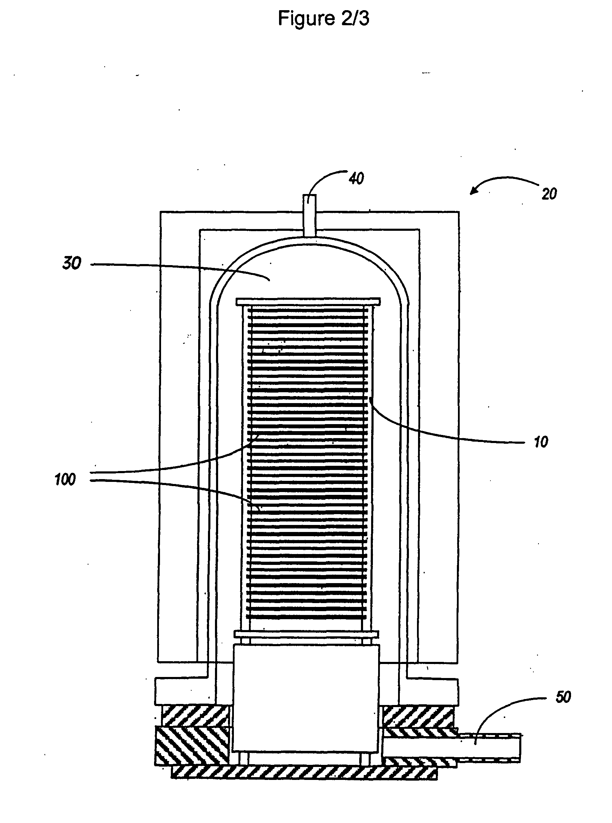

An exemplary substrate support or susceptor plate 100, according to the preferred embodiments is illustrated in Figure 1. The susceptor 100 preferably has a support surface 110 which extends across the entire bottom surface of a substrate that the susceptor 100 will support. In the illustrated embodiment, the surface 110 is contiguous, other than for three holes 130. Preferably, the susceptor 100 has a diameter larger than the diameter of the substrate. It will be appreciated that, while circular in the illustrated embodiment, the susceptor plate 100 can be any shape. The susceptor 100 is sized and shaped to fit into a wafer boat 10 (Figure 2). The susceptor 100 is preferably less than about 4 mm thick, more preferably less than about 3 mm thick and, most preferably, less than about 2 mm thick. Because thicker susceptors heat-up and cool down more slowly than thinner susceptors, the susceptors 100 are preferably similar in thickness to the thickness of the substrates that they will support. This advantageously allows the susceptor to better approximate the thermal properties of the substrate, to help minimize slip lines, as discussed below. To minimize the occurrence of large gaps between the susceptor plate 100 and a supported substrate, the support surface 110 for supporting a substrate thereon is preferably substantially flat and without any major protrusions.

For better slip performance, *e.g*., to form semiconductor wafers with no slip lines at all or a relatively low number of slip lines, the susceptor 100 preferably has a surface with a minimum surface roughness. It has been found that susceptor plates with a surface roughness of Ra = 0.5 µm or less undesirably cause the formation of thousands of slip lines, even where the overall flatness of the susceptor is low, *e.g*., within the limits disclosed in U.S. Patent Application Publication No. 20040040632 A1. Preferably, the contact surface 110, which directly contacts substrates, has a surface roughness Ra value equal to about 0.6 µm or more, more preferably, an Ra value equal to about 1.0 µm or more and, most preferably, an Ra value equal to about 2.0 µm or more. The surface roughness can be measured with a surface profilometer commercially available from Mitutoyo Corporation of Japan. Preferably, the surface roughness is uniform over the entire surface 110 that is configured to contact with a substrate.

With continued reference to Figure 1, a raised shoulder or edge 120 can optionally be provided at the circumference of the susceptor plate 100. During heat-up, the raised edge 120 shields the substrate edge against excessive heat radiation, advantageously preventing the substrate edge from overheating. During cool-down, the raised edge 120 shields the substrate from cooling too rapidly. Furthermore, the raised edge 120 prevents the substrate from moving horizontally during transport of the susceptor plate 100 with a substrate thereon. The susceptor plate 100 is also optionally provided with three through holes 130 to facilitate automatic substrate loading using pins (not shown) which protrude through the holes 130 to, *e.g*., support and lower the substrate onto the surface 110 during substrate loading. The holes 130 are preferably located proximate to locations corresponding to the periphery of the substrate (preferably within 5 mm, more preferably within 3 mm of the substrate's edge, when a substrate is supported on the susceptor plate 100).

While the susceptor 100 can be used to support a substrate in any processing environment or chamber, it will be appreciated that the suseptor plate 100 can advantageously be accommodated in a substrate support holder or wafer boat 10, in a batch reactor 20 during substrate processing, as shown schematically in Figure 2. The illustrated reactor 20 is a vertical furnace in which process gases can be fed into the reaction chamber 30 via the inlet 40 at the top of the chamber 30. The gases can be evacuated out of the chamber 30 from the exhaust 50 at the bottom of the chamber 30. It will be appreciated that the exhaust 50 and inlet 40 can be otherwise configured. For example, the inlet 40 can be located at the bottom of the chamber 30, or can comprise multiple vertically spaced holes along the height of the boat 10. The reaction chamber 30 accommodates the wafer boat 10, which holds a stack of vertically spaced susceptors 100 upon which wafers are supported. A suitable, exemplary batch reactor is commercially available under the trade name A400™ or A412™ from ASM International, N.V. of the Netherlands. The skilled artisan will appreciate, however, that the principles and advantages disclosed herein will have application to other types of reactors, including other batch reactors. The reactors are preferably configured to treat substrates at about 1000°C or greater.

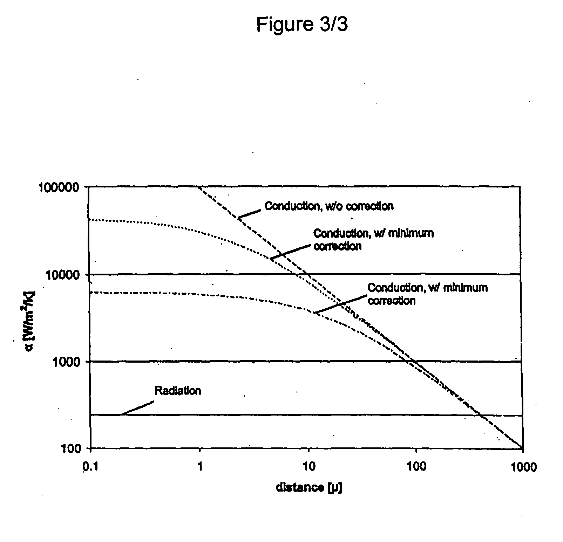

As discussed above, while the invention is not limited by theory, it is believed that an appropriately rough susceptor plate surface 110 results in a more gentle or moderate thermal contact and heat transfer. Figure 3 is a graph illustrating calculations for various heat transfer coefficients (α [W/m²/K]) due to conduction through gas and due to radiation as a function of the distance between a substrate and a susceptor, at 1350°C at atmospheric pressure in nitrogen. As can be seen, the heat transfer coefficient due to radiation does not vary as a function of the distance between the substrate and the susceptor. The heat transfer due to conduction through the gas, however, is inversely proportional to the distance between the substrate and the susceptor.

With continued reference to Figure 3, conduction will be the dominant mechanism of heat transfer where a substrate directly contacts a susceptor. On a very smooth surface the substrate will make contact with the susceptor on some spots but, due to the non-flatness of the substrate and/or the susceptor, there will be gaps between the substrate and the susceptor at other locations. These gaps can easily be in the hundreds of microns. Thus, as evident on the graph, thermal contact at the contact spots between the substrate and the susceptor can be extremely good, whereas the thermal contact can be a few orders of magnitude less where there is a gap between the substrate and the susceptor.

It will be appreciated that, in theory, the heat transfer coefficient for conduction is infinite at contact spots. This is not necessarily true in practice, however, because there can be some separation between the substrate and the susceptor even in these contact areas. For example, when the separation between the substrate and the susceptor becomes less than the mean free path of the gas molecules in the contact areas, a correction factor is applied to the heat transfer coefficient because the gas can no longer be considered a continuum: collisions of gas molecules with the walls become dominant and collisions between gas molecules become rare. The mean free path for the conditions of the illustrated example is about 0.37 µm. In this situation the inversely proportional relationship does not hold; rather, for some range of small distances, the heat transfer can be relatively level, as would occur in the case of heat transfer due to radiation. As the correction factor is not precisely known, various assumptions were made. Figure 3 shows curves having the minimum and the maximum values of these correction factor assumptions.

It is believed that increasing surface roughness has an effect similar to increasing the spacing between the substrate and susceptor. The result is that the heat transfer coefficient is reduced at the contact areas and the variation in the heat transfer coefficient over the surface of the substrate (*e.g*., the difference between minimum and maximum value heat transfer values) becomes smaller. This effect aids in moderating and evening-out the heat transfer between the substrate and the susceptor, thereby minimizing local non-uniformities in temperature and reducing the incidence of slip.

The roughness of the substrate contact surface of a susceptor can be increased in various ways. For example, the surface can be roughened by mechanical means. A preferred method is "sand blasting." The sand blasting can be performed with silicon carbide grit as the abrasive particles, with the size of the particles chosen based upon the desired surface roughness. Other mechanical methods known in the art for roughening surfaces can also be used, including, without limitation, brushing, grinding, etc.

Another method for roughening the contact surface is to deposit a film that forms a rough surface. An example of such a film is a polysilicon film, which exhibits a relatively rough surface when deposited to a thickness of about 0.5 µm or more. Advantageously, a polysilicon film can also serve as a getter layer that traps impurities in the bulk of the film. Use of polysilicon also allows the rough surface to be periodically renewed. For example, the polysilicon film can be removed after a number of runs by high temperature chlorine etching or low temperature wet chemical etching. Together with the polysilicon film, any impurities gettered in the film can be removed. Before further use, a fresh polysilicon film can be deposited, *e.g.*, by chemical vapor deposition.

Yet another method for roughening the surface is to chemically treat the surface. A preferred method is to react the susceptor surface with oxygen at high temperature. For example, roughening susceptor plates by oxidation at 1320°C for 10 hours in about 50% O₂ in an inert gas was found to result in a strong reduction in the number of slip lines, compared to the untreated susceptor plates. On the other hand, chemical cleaning that removes the silicon oxide film on a susceptor can cause the susceptors to be changed from a susceptor on which processed substrates have few slip lines into a susceptor on which processed substrates have many slip lines. Advantageously, an oxidation treatment can be applied to again form a susceptor surface with the desired roughness.

It will be appreciated, however, that oxidation can be problematic for susceptors that are used in an inert or a non-oxidizing ambient. For example, in such an environment, silicon oxide formed on the susceptor surface might evaporate, leaving only the bare susceptor surface behind. In such cases, the susceptor surface itself preferably already has the desired roughness, allowing the susceptor to show good slip performance in silicon substrates processed on it from the first run on, whether in oxidizing, in inert or in reducing ambients.

Preferably, for high temperature processing, the susceptor is formed of SiC, because of its heat resistance and high purity. The SiC is preferably chemical vapor deposited (CVD) SiC. The CVD SiC can be deposited on sintered SiC material, in a thickness sufficient to seal the sintered SiC material adequately.

More preferably, the susceptor plates are made of so-called "free-standing" CVD SiC. This is a SiC coating, initially deposited on a support material but with a thickness that is sufficient to allow removal of the support material (*e.g.*, graphite), in a process analogous to a "lost wax" method of transferring molds. See U.S. Patent No. 4,978,567, issued December 18, 1990 to Miller, the entire disclosure of which is incorporated herein by reference. When the designed shape of the susceptor plate requires machining, the machining can be performed in reverse, *i.e*., on the support material before deposition of the CVD SiC coating. This advantageously allows machining of the hard CVD SiC material to be omitted or reduced to a minimum. ln other embodiments, the CVD SiC can be deposited on a flat support material and the CVD SiC can be machined according to requirements.

The CVD silicon carbide film can be deposited in a manner, for example, as set forth in US Patent No. 4,772,498, issued September 20, 1988, the entire disclosure of which is incorporated herein by reference. Silicon containing gas used to form the silicon carbide coating can be selected from the group consisting of silane, chlorosilane, trichlorosilane, silicon tetrachloride, methyltrichlorosilane and di-methyldichlorosilane. If silane, chlorosilane, trichlorosilane or silicon tetrachloride is used, a carbon source is additionally supplied to produce silicon carbide. The source of carbon can be any hydrocarbon. Preferred hydrocarbons do not contain oxygen and include low molecular weight aliphatic hydrocarbons such as parafins, alkenes and alkynes having 1 to 6 carbon atoms, and aromatics and other hydrocarbons having 1 to 6 carbon atoms. Particularly suitable examples include methane, ethane, propane, butane, methylene, ethylene, propylene, butylenes, acetylene, and benzene. The deposition temperature is preferably in a range from about 1100°C to about 1500°C, more preferably, in a range from about 1200°C to about 1400°C. Preferably, the deposition is performed at about atmospheric pressure.

In either case, the support surface of the susceptor plate is preferably subjected to a grinding and/or polishing treatment after deposition of the SiC material in order to remove any protrusions present on it. It will be appreciated that incidental protrusions on the contact surface are generally harmful and can result in the occurrence of local plastic deformation of a silicon substrate resting on the protrusion. Thus, while the susceptor surface is preferably rough, as described above, isolated protrusions on the susceptor surface are preferably minimal. The susceptor surface is preferably roughened after this polishing to achieve the desired surface roughness.

In addition or as an alternative to maintaining a minimum surface roughness, the effect of differences in heat transfer coefficients across the surface of a substrate can be decreased by minimizing the amount of heat transfer that occurs. In some preferred embodiments, the susceptor is formed with heat absorption characteristics closer to the heat absorption characteristics of the substrate, so that the heat up at rates for the susceptor and the substrate are more similar than would otherwise be the case.

For example, where the susceptor plates are made of SiC and the substrate are silicon wafers, the SiC is preferably a low transparency silicon carbide, to better match or approximate the heat absorption characteristics of silicon wafers. It will be appreciated that silicon carbide, which is a high band gap semiconductor, is normally relatively transparent to heat radiation, even at elevated temperature. As a consequence, an object made of stoichiometric SiC typically absorbs only about 30% of the heat radiation impinging on its surface. In contrast, at elevated temperatures, a silicon wafer absorbs about 90% or more of the heat radiation that impinges on its surface. When a silicon wafer supported on a transparent silicon carbide susceptor plate is heated, these differences in heat absorption characteristics cause temperature differences between the silicon wafer and the silicon carbide susceptor plate; the wafer heats up more quickly than the susceptor.

In addition, as noted above, it is difficult to form perfectly flat wafers and perfectly flat susceptors. Consequently, as also noted above, differences in flatness between the wafer and the susceptor can cause non-homogeneous thermal contact over the wafer's surface, which can cause local temperature gradients in the wafer, which in turn can undesirably cause crystallographic slip. It will be appreciated that the severity of the local temperature gradients is related to the temperature difference between the wafer and the susceptor; for example, a large temperature difference leads to a large thermal gradient between the wafer and the susceptor, which causes more heat transfer at the points of good thermal contact, which more greatly alters the temperature of the wafer at those points of good contact, thereby increasing the local temperature gradients on the wafer. As a result, to minimize these effects, the susceptor preferably closely matches the temperature of an overlying substrate throughout processing.

This temperature matching can be achieved by more closely matching the heat absorption characteristics of the susceptor and the substrate. For example, CVD silicon carbide susceptors can be made to absorb more heat from the reactor heating mechanism by making them less transparent. The transparency of the CVD SiC susceptor plate is preferably less than about 50%, more preferably less than about 30% and, most preferably, less than about 10%.

The transparency of the susceptor can be decreased in various ways. In some embodiments, various transparency-reducing materials are added to the susceptor to decrease the transparency of the silicon carbide material. For example, the transparency of silicon carbide can be strongly reduced by doping the silicon carbide so that it is not an intrinsic semiconductor anymore. Preferably, the doping element is silicon or carbon; that is, the SiC is preferably formed having a silicon/carbon ratio that deviates slightly from the stoichiometric ratio of 1:1. Preferably, this is accomplished by growing a carbon-rich film having a carbon:silicon ratio of 1.01:1 or more, more preferably, a carbon: silicon ratio of 1.05:1 or more. Other doping elements include, without limitation, elements such as germanium or elements from Group III or Group V of the periodic table of elements.

Also, it will be appreciated that the microstructure of the SiC can be altered to change its transparency. The transparency of silicon carbide is strongly influenced by its microstructure: transparent SiC is highly oriented towards the 111 axis direction and is characterized by pure, essentially defect-free, cubic beta-SiC columnar grains that are 5-10 micron in size; translucent SiC is mostly cubic in structure but contains a large number of twins; opaque CVD SiC is randomly oriented, does not exhibit columnar grains and contains one directional disorder with hexagonal (alpha-SiC) symmetry in a majority of grains and a high density of dislocations elsewhere. See, MICROSTRUCTURE COMPARISON OF TRANSPARENT AND OPAQUE CVD SiC, Kim, Y.; Zangvil, A.; Goela, J. S.; Taylor, R. L.; J. Am. Ceram. Soc. Vol. 78, No.6, 1995, pp1571-1579, the entire disclosure of which is incorporated herein by reference. Preferably, a SiC susceptor is formed having a SiC microstructure that results in the susceptor being translucent or opaque. The microstructure of the SiC can be adjusted by adjusting the conditions of the CVD process such as temperature, choice of silicon and carbon containing source gases, partial pressure of the source gases, carrier gas used, etc.

It will be appreciated that the material forming the susceptor can be homogenous or non-homogeneous. For example, where the susceptor is formed of a low transparency SiC material, such as a non-stoichiometric SiC material, as noted above, the CVD SiC can be homogeneous in composition.

In other embodiments, the composition of the material forming the susceptor can vary. For example, a sandwich structure can be grown in which the outer parts of the SiC coating is grown stoichiometric for optimal chemical resistance and an inner part of the coating is grown non-stoichiometrially for decreased transparency. The silicon/carbon ratio can be adjusted by adjusting the ratio between the silicon source gas and carbon source gas. Alternatively, a composite film can be formed, comprising two or more stoichiometric silicon carbide films with one or more non-stoichiometric silicon carbide films in between. In addition, as it can be difficult to for a thermally activated CVD process at high temperature to deposit a film with a composition that deviates from a stoichiometric composition, the composite film can also comprise one or more carbon films stacked in-between two or more stoichiometric silicon carbide films.

### Example:

A wafer was processed while supported on a susceptor having a surface roughness of Ra=0.3 µm. The wafer was found to have several thousands of slip lines after processing. The susceptor was then sand blasted and an increased surface roughness of Ra=2.0 µm was measured on the susceptor. A silicon wafer was processed supported while supported on the susceptor's surface. The wafer was treated at 1320°C for 10 hours or more. After processing, only a few slip lines could be detected.

A second susceptor having a surface roughness of Ra=0.5 µm was also tested by processing a wafer supported on that susceptor. The wafer also was found to have several thousands of slip lines after processing. After sand blasting increased the surface roughness to Ra=1.8 µm, no slip lines were detected after processing a silicon wafer supported on the susceptor.

Thus, use of a susceptor having a roughness as described above advantageously results in processed wafers having few slip lines. Preferably, the wafers each have about 500 slip lines or less and, more preferably, about 100 slip lines or less and, more preferably, about 50 slip lines or less. For particularly critical applications which are particularly sensitive to the occurrence of slip lines, not only is the number of slip lines important, but also their accumulated length. The accumulated length of all slip lines in a wafer for these critical applications preferably is less than about 10 mm, more preferably less than about 1 mm. Moreover, forming all susceptors in a wafer boat with a roughness as described above allows improved uniformity of results from wafer to wafer; advantageously, by ensuring that the susceptors uniformly have a desired surface roughness, the wafers exhibit a uniformly low number of slip lines.

As noted above, the susceptor plates are preferably made of free-standing CVD SiC, as this material is known for its high purity and heat resistance. Depending on the process conditions that a substrate supported on the susceptor will be subjected to, however, other materials with the above-described roughness are also suitable. For example, the above-described surface roughness can be applied to other SiC materials, such as converted graphite, sintered SiC, silicon impregnated sintered SiC, or a material coated with CVD SiC. Advantageously, under appropriate circumstances, a susceptor formed with these materials may possess a surface roughness that is larger than that of free-standing CVD SiC, even without additional processing of the susceptor.

It will be appreciated by those skilled in the art that various other omissions, additions and modifications may be made to the methods and structures described above without departing from the scope of the invention. All such modifications and changes are intended to fall within the scope of the invention, as defined by the appended claims.

## Claims

1. A semiconductor substrate support, comprising:
an upper surface configured to directly contact and support a semiconductor substrate, wherein the upper surface has a surface roughness Ra value of about 0.6 µm or more.

2. The semiconductor substrate support of Claim 1, wherein the Ra value is about 1.0 µm or more.

3. The semiconductor substrate support of Claim 1, wherein the Ra value is about 2.0 µm or more.

4. The semiconductor substrate support of at least one of Claims 1 to 3, wherein the upper surface comprises an oxide coating.

5. The semiconductor substrate support of at least one of Claims 1 to 3, wherein the upper surface comprises a polysilicon coating.

6. The semiconductor substrate support of Claim 5, wherein the polysilicon coating is about 0.5 µm or thicker.

7. The semiconductor substrate support of at least one of Claims 1 to 6, wherein a heat absorption of the support approximates a heat absorption of the substrate.

8. The semiconductor substrate support of at least one of Claims 1 to 7, wherein the support absorbs more than about 30% of heat radiation impinging on exposed surfaces of the support.

9. The semiconductor substrate support of at least one of Claims 1 to 8, wherein the support is formed of silicon carbide material.

10. The semiconductor substrate support of Claim 9, wherein the silicon carbide material has a homogenous structure.

11. The semiconductor substrate support of Claim 10, wherein the silicon carbide material comprises stoichiometric SiC and non-stoichiometric SiC.

12. The semiconductor substrate support of at least one of Claims 9 to 11, wherein a transparency of the silicon carbide material is less than about 50%.

13. The semiconductor substrate support of Claim 12, wherein the transparency is less than about 10%.

14. The semiconductor substrate support of at least one of Claims 9 to 13, wherein the silicon carbide material is doped with one or more elements selected from the group consisting of germanium and elements from Group III and Group V of the periodic table.

15. The semiconductor substrate support of at least one of Claims 9 to 10 and 12 to 14, wherein a ratio of silicon to carbon in the silicon carbide material is non-stoichiometric.

16. The semiconductor substrate support of at least one of Claims 9 to 15, wherein the silicon carbide material has a randomly oriented microstructure.

17. The semiconductor substrate support of at least one of Claims 1 to 8, wherein the support comprises a layer of stoichiometric silicon carbide formed over a layer of carbon.

18. The semiconductor substrate support of at least one of Claims 1 to 17, wherein the upper surface extends substantially across an entire bottom surface of the wafer.

19. The semiconductor substrate support of at least one of Claims 1 to 18, wherein the substrate is a silicon wafer and wherein the support is a susceptor plate configured to be accommodated in a wafer boat.

20. The semiconductor substrate support of at least one of Claims 1 to 3 and 7 to 19, wherein the upper surface is a sand-blasted surface.

21. A batch reactor, comprising:
- a vertical furnace having a reaction chamber;
- a substrate support holder configured to be accommodated in the reaction chamber, wherein the substrate support holder comprises a plurality of slots for substrate supports; and
- a plurality of substrate supports for supporting semiconductor substrates, each substrate support having a substrate contact surface with a surface roughness Ra value of about 0.6 µm or more,
wherein the substrate supports are each configured to be accommodated in one of the plurality of slots.

22. The reactor of Claim 21, wherein each substrate support has an Ra value of about 1.0 µm or more.

23. The reactor of Claim 21 or 22, wherein each substrate support has an Ra value of about 2.0 µm or more.

24. The reactor of at least one of Claims 21 to 23, wherein the substrate supports comprise silicon carbide material.

25. The reactor of Claim 24, wherein a transparency of the silicon carbide material is less than about 50%.

26. The reactor of Claim 24 or 25, wherein the transparency is less than about 10%.

27. The reactor of at least one of Claims 21 to 26, wherein the substrate support holder is a wafer boat which accommodates the susceptors vertically spaced from one another and with major surfaces of the susceptors oriented horizontally.

28. The reactor of at least one of Claims 21 to 27, wherein the substrate supports are susceptor plates.

29. The reactor of at least one of Claims 21 to 28, wherein the furnace comprises a process gas inlet proximate a top of the reaction chamber and a process gas exhaust proximate a bottom of the reaction chamber.

30. The reactor of at least one of Claims 21 to 29, wherein the furnace is configured to process the substrates at about 1000°C or more.
